# EUROPEAN PATENT APPLICATION

(11) **EP 2 613 360 A1**
(43) Date of publication of application: **10.07.2013**
(21) Application number: 11821286.9
(22) Date of filing: 25.08.2011
(51) Int. Cl.: H01L 31/042

(54) **METHOD FOR PRODUCING PHOTOVOLTAIC CELL MODULE**

(30) Priority: 03.09.2010 JP 2010198095
(71) Applicant: Fuji Electric Co., Ltd., Kawasaki-shi Kanagawa 210-9530 (JP)
(72) Inventor: YOSHIDA, Takashi, Kawasaki-shi Kanagawa 210-9530 (JP); YOKOYAMA, Shoji, Kawasaki-shi Kanagawa 210-9530 (JP)
(74) Representative: MERH-IP Matias Erny Reichl Hoffmann
(86) International application number: PCT/JP2011/004735
(87) International publication number: WO 2012/029263

(57) **Abstract**

On a lamination frame (100) is disposed a stacked member of photovoltaic cells (202) and a concave-convex member (300). The photovoltaic cells (202) are formed using a flexible substrate. When forming the stacked member, each of the plurality of photovoltaic cells (202) is disposed on a lamination frame (100) in the state of an intermediate member (200) sandwiched between protective films for lamination and sealing. Among the protective films, the protective film positioned on the side of the light-receiving face of the photovoltaic cells (202) is opposed entirely by the concave-convex member (300). The concave-convex member (300) has concavities and convexities on the surface opposing the protective film. By simultaneously subjecting the intermediate member (200) and the concave-convex member (300) to lamination treatment, a plurality of photovoltaic cells (202) can be simultaneously and individually sealed by the protective film.

## Description

### TECHNICAL FIELD

This invention relates to a method of manufacturing a photovoltaic module having a photovoltaic cell formed on a flexible substrate.

### BACKGROUND ART

In recent years there has been a burgeoning movement toward environmental responsibility, and this has been attended by advancing adoption of photovoltaic devices. In order to impart durability to photovoltaic devices, a sealing material must be used to seal photovoltaic cells. When photovoltaic cells are formed using a flexible substrate, often the photovoltaic cells are sealed using a laminating method (see for example Patent Documents 1 to 8).

Patent Document 1: Japanese Patent Application Publication No. 2004-311571
Patent Document 2: Japanese Patent Application Publication No. 2008-296583
Patent Document 3: Japanese Patent Application Publication No. 2010-12786
Patent Document 4: Japanese Patent Application Publication No. 2010-23485
Patent Document 5: Japanese Patent Application Publication No. 2010-149506
Patent Document 6: Japanese Patent Publication No. 2948508
Patent Document 7: Japanese Patent Publication No. 3176264
Patent Document 8: Japanese Patent Publication No. 3288876

In order to lower the cost of photovoltaic modules, the efficiency of production of photovoltaic modules must be improved.

### DISCLOSURE OF THE INVENTION

This invention was devised in light of the abovementioned circumstances, and has as an object provision of a method of manufacturing photovoltaic modules with improved production efficiency.

A method of manufacturing photovoltaic modules of this invention has the following steps. First, a stacked member is formed in which a plurality of photovoltaic cells each sandwiched between protective films for lamination and sealing, and at least one concave-convex member, are superposed. In this stacked member, all the photovoltaic cells are superposed in a state in which the protective film positioned on the side of the light-receiving face is opposed to a concave-convex member. The plurality of photovoltaic cells are simultaneously and individually sealed by the protective film by implementing simultaneous lamination treatment of the stacked member.

By means of this invention, the efficiency of production of photovoltaic modules can be improved.

### BRIEF DESCRIPTION OF THE DRAWINGS

The above-described object, as well as other objects, features and advantages will become clearer through the following preferred embodiments and the accompanying drawings.

Fig. 1 is a cross-sectional view used to explain the configuration of a laminating device used in the method of manufacturing photovoltaic modules of a first embodiment;
Fig. 2 is a cross-sectional view showing the configuration of an intermediate member;
Fig. 3 explains a method of manufacturing photovoltaic modules using the laminating device shown in Fig. 1;
Fig. 4 is a cross-sectional view showing the method of manufacturing photovoltaic modules of a second embodiment;
Fig. 5 is a cross-sectional view showing the method of manufacturing photovoltaic modules of a third embodiment;
Fig. 6 is a cross-sectional view used to explain the configuration of a laminating device used in the method of manufacturing photovoltaic modules of a fourth embodiment;
Fig. 7 is a view used to explain a method of manufacturing photovoltaic modules using the laminating device shown in Fig. 6; and
Fig. 8 is a cross-sectional view used to explain the method of manufacturing photovoltaic modules of a fifth embodiment.

### BEST MODE FOR CARRYING OUT THE INVENTION

Below, embodiments of the invention are explained using the drawings. In all of the drawings, the same constituent elements are assigned the same symbols, and explanations are omitted as appropriate.

### (First Embodiment)

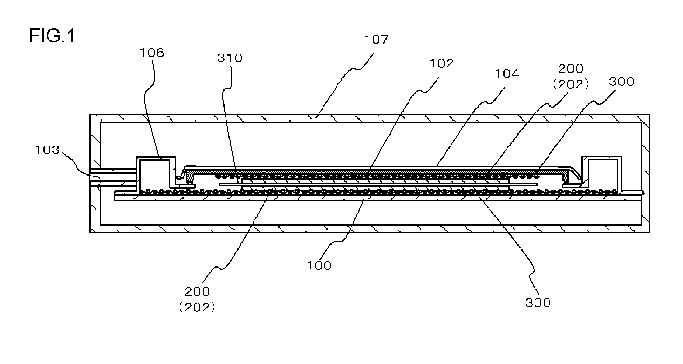

Fig. 1 is a cross-sectional view used to explain the configuration of a laminating device used in the method of manufacturing photovoltaic modules of a first embodiment.
When this laminating device is used, photovoltaic modules are manufactured on a basis of following steps. On a lamination frame 100 is disposed a stacked member of photovoltaic cells 202 and concave-convex members 300. The photovoltaic cells 202 are formed using a flexible substrate. When forming this stacked member, each of the plurality of photovoltaic cells 202 is disposed on the lamination frame 100 in the state of an intermediate member 200, sandwiched between protective films for lamination and sealing. Of the protective films, the protective films positioned on the side of the light-receiving face of the photovoltaic cells 202 are opposed by all of the concave-convex members 300. The concave-convex members 300 have concavities and convexities in the face opposing the protective film. By simultaneously performing lamination treatment of the stacked member of the intermediate member 200 and the concave-convex members 300, a plurality of photovoltaic cells 202 is simultaneously and individually sealed by the protective film.

In the laminating device shown in Fig. 1, a framework 106 is mounted on the edge of the lamination frame 100. The framework 106 has an evacuation port 103. On the framework 106 is removable mounted an upper lid 102 and a diaphragm sheet 104. When the upper lid 102 and diaphragm sheet 104 are mounted on the framework 106, a closed space is formed by the lamination frame 100, framework 106 and upper lid 102. Within this closed space is disposed the stacked member of the intermediate members 200 and the concave-convex members 300. And within this closed space, evacuation is possible via the evacuation port 103. The lamination frame 100, framework 106, upper lid 102, and diaphragm sheet 104 are positioned within a heating furnace 107.

The laminating device has a concave-convex member 300 above the lamination frame 100 as well. In the stacked member of the intermediate members 200 and the concave-convex members 300, the plurality of photovoltaic cells 202 are disposed such that the light-receiving faces are oriented alternately in upward and downward directions. In the example shown in Fig. 1, the stacked member has two intermediate members 200. In the stacked member 200 positioned relatively lower, the light-receiving faces of the photovoltaic cells 202 are directed downward. And in the stacked member 200 positioned relatively higher, the light-receiving faces of the photovoltaic cells 202 are directed upward. Between the two intermediate members 200 is positioned a separation sheet 310. The separation sheet 310 is provided to prevent mutual adhesion during lamination treatment of the protective films of the two intermediate members 200. Concavities and convexities are formed on the top and bottom surfaces of the separation sheet 310 as well; the depths of the concavities and convexities may be approximately the same as that of the concavities and convexities provided in the concave-convex members 300. By means of the convex/concave shapes in the separation sheet 310, evacuation air routes are formed between the intermediate members 200 and the separation sheet 310 during lamination treatment.

The concave-convex members 300 can for example be a metal mesh, and a metal sheet in which a plurality of holes have been formed can be used. By using the concave-convex members 300, concavities and convexities are formed in the light-receiving faces of photovoltaic modules, and by this means reflection of light at the light-receiving faces of the photovoltaic modules can be suppressed. Also, by means of the concave/convex shapes of the concave-convex members 300, evacuation air routes are formed between the intermediate members 200 and the concave-convex members 300 during lamination treatment.

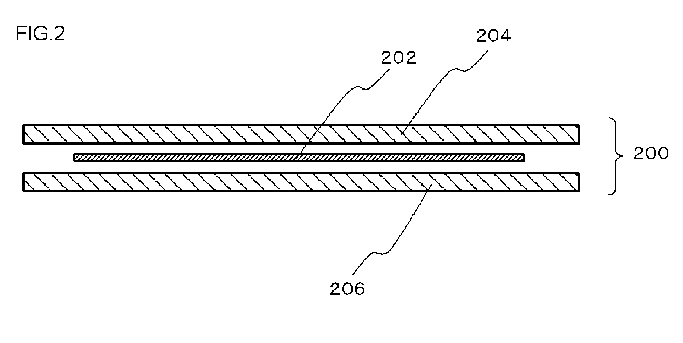

Fig. 2 is a cross-sectional view showing the configuration of an intermediate member 200. The intermediate member 200 is formed by sandwiching photovoltaic cells 202 between protective films 204 and 206. The protective film 204 is provided on the side of the light-receiving face of the photovoltaic cells 202, and the protective film 206 is provided on the side of the rear face of the photovoltaic cells 202. The protective film 204 always opposes the above-described concave-convex member 300 when lamination treatment is performed, and after lamination treatment, concavities and convexities are formed on the surface.

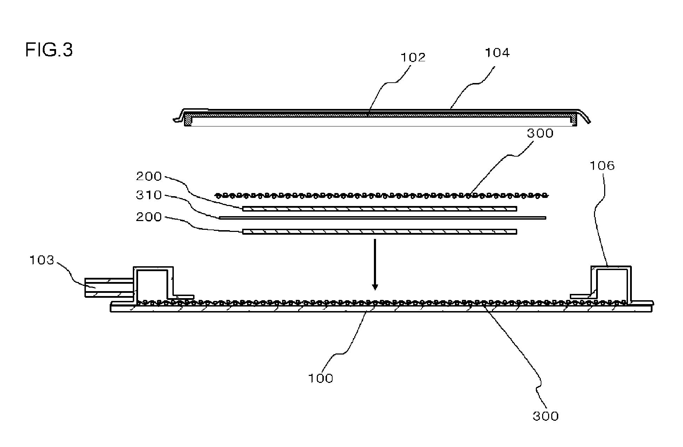

Next, Fig. 3 and Fig. 1 are used to explain in detail a method of manufacturing a photovoltaic module using the laminating device shown in Fig. 1. As shown in Fig. 3, first the upper lid 102 and diaphragm sheet 104 are removed from the framework 106. Then, on the concave-convex member 300 on the lamination frame 100, an intermediate member 200 is disposed such that the protective film 204 (shown in Fig. 2) is directed downward. Next, the separation sheet 310 is disposed on the intermediate member 200, and then the next intermediate member 200 is disposed on the separation sheet 310. This intermediate member 200 is disposed such that the protective film 204 is directed upward. Next, a concave-convex member 300 is disposed on this intermediate member 200.

Next, as shown in Fig. 1, the upper lid 102 and diaphragm sheet 104 are disposed on the framework 106. Next, evacuation is performed through the evacuation port 103. The closed space between the upper lid 102 and the lamination frame 100 is then evacuated. At this time, evacuation routes between the intermediate members 200 and the separation sheet 310 are secured by the concave/convex shapes of the separation sheet 310. Similarly, evacuation routes between the intermediate members 200 and the concave-convex members 300 are secured by the concave/convex shapes of the concave-convex members 300. Hence the partial retention of air between the intermediate members 200 and the separation sheet 310, and between the intermediate members 200 and the concave-convex members 300, can be suppressed.

The stacked member of the intermediate members 200 and the concave-convex members 300 is subjected to atmospheric pressure, which acts on the stacked member of the intermediate members 200 and the concave-convex members 300 via the diaphragm sheet 104 and upper lid 102. In this state, the stacked member of the intermediate members 200 and the concave-convex members 300 is heated by the heating furnace 107, and the protective films 204 and 206 in each of the intermediate members 200 mutually adhere. By this means the photovoltaic cells 202 are sealed by the protective films 204 and 206, and the photovoltaic module is formed.

At this time, the concavities and convexities of the concave-convex members 300 are transferred onto the protective films 204 on the sides of the light-receiving faces of the photovoltaic cells 202, and the concavities and convexities of the separation sheet 310 are formed in the protective films 206 on the rear-face sides of the photovoltaic cells 202. As explained above, the depths of the concavities and convexities in the separation sheet 310 may be approximately the same as those of the concavities and convexities in the concave-convex members 300. Due to the concavities and convexities on the side of sunlight incidence, reflection of sunlight at the top surface of the photovoltaic module is suppressed, and sunlight can be effectively captured in photovoltaic cells; moreover, brightness and other influences on human environments due to reflection by installed photovoltaic devices can also be reduced. The concavities and convexities on the bottom surfaces can increase the adhesion area in adhesion and adherence-fixing when installing photovoltaic device terminal boxes and photovoltaic modules, and consequently adhesion can be improved.

Thereafter, wiring (not shown) to extract the output from the photovoltaic cells 202 is drawn to the outside via the protective films 204 or protective films 206.

Next, the action and advantageous effects of this embodiment are explained. By means of this embodiment, a plurality of photovoltaic cells 202 can be sealed simultaneously and individually by the protective films 204 and 206, and a plurality of photovoltaic modules can be simultaneously manufactured. Hence the efficiency of production of photovoltaic modules can be raised. Further, in order to raise the efficiency of power generation of photovoltaic modules, it is important that concavities and convexities be formed in the light-receiving face of the photovoltaic modules so that light reflection is suppressed; in this embodiment, the concave-convex members 300 are disposed so as to be opposed to all of the protective films 204, so that concavities and convexities can be formed in the light-receiving faces of all photovoltaic modules.

Further, in this embodiment the plurality of photovoltaic cells 202 have light-receiving faces oriented alternately in upward and downward directions. Further, by using different concavities and convexities in the concave-convex members 300 and the separation sheet 310, the concavity depth and convex height, patterns and similar can be changed on the light-receiving faces and rear faces of the photovoltaic modules.

### (Second Embodiment)

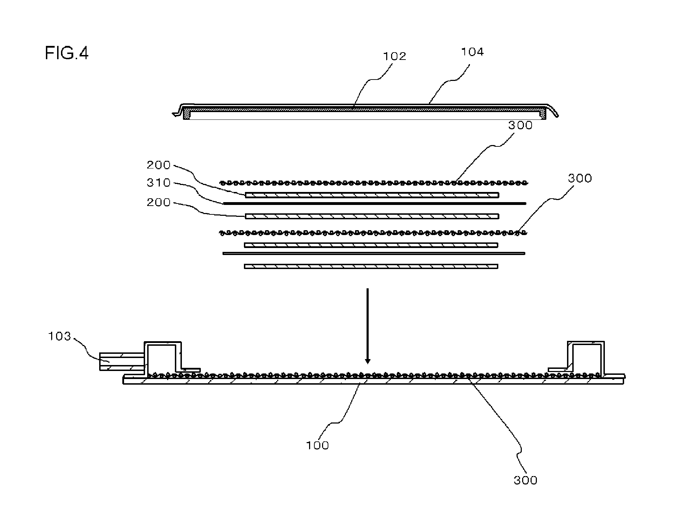

Fig. 4 is a cross-sectional view showing the method of manufacturing photovoltaic modules of a second embodiment, and corresponds to Fig. 3 in the first embodiment. The method of manufacturing photovoltaic modules of this embodiment is similar to the method of manufacturing photovoltaic modules of the first embodiment, except in the following respects.

First, a stacked member of intermediate members 200 and concave-convex members 300 has a configuration in which are superposed at least two second stacked members formed of an intermediate member 200, a separation sheet 310, and an intermediate member 200. In a second stacked member, the two intermediate members 200 have photovoltaic cells 202 the rear faces of which are mutually opposed. Between the second stacked members is disposed a concave-convex member 300. The concave-convex member 300 here disposed is for example a metal mesh, in both faces of which similar concavities and convexities are formed. In this embodiment also, concave-convex members 300 are disposed on the uppermost-layer intermediate member 200 and on each of the lamination frames 100.

By means of this embodiment also, advantageous results similar to those of the first embodiment can be obtained. Further, at least four photovoltaic modules can be manufactured simultaneously, so that the efficiency of production of photovoltaic modules can be further raised. And, the concave-convex members 300 and separation sheets 310 to form concavities and convexities in the light-receiving faces and rear faces of the photovoltaic modules can form concavities and convexities in two photovoltaic modules by means of only one concave-convex member 300 or separation sheet 310, except those positioned below the lower layer or above the upper layer of the stacked plurality of photovoltaic cells 202.

### (Third Embodiment)

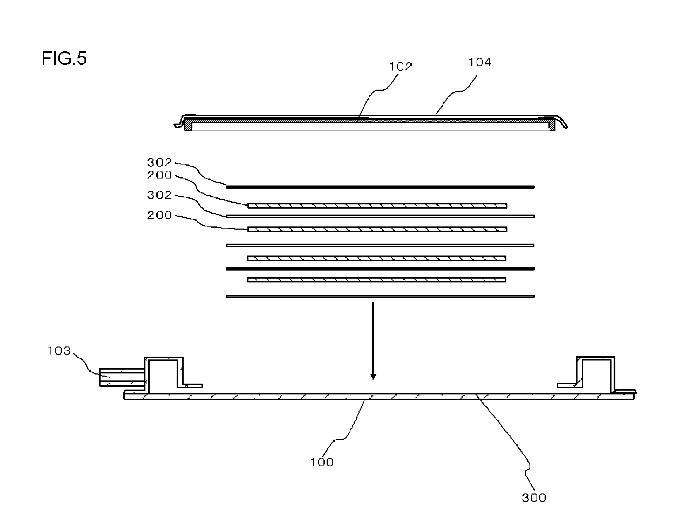

Fig. 5 is a cross-sectional view showing the method of manufacturing photovoltaic modules of a third embodiment, and corresponds to Fig. 3 in the first embodiment. The method of manufacturing photovoltaic modules of this embodiment is similar to the method of manufacturing photovoltaic modules of the first embodiment, except in the following respects.

First, the light-receiving faces of a plurality of intermediate members 200 are directed in the same direction. And, intermediate members 200 and concave-convex members 302 are superposed in alternation. Between the lowest intermediate member 200 and the lamination frame 100, and above the highest intermediate member 200, are disposed concave-convex members 302. The top surface of each of the concave-convex members 302 is in contact with the intermediate member 200 positioned on the upper side, and the bottom surface is in contact with the intermediate member 200 positioned on the lower side. When the light-receiving faces of the intermediate members 200 are directed upwards, the bottom surface of each of the concave-convex members 302 is in contact with the light-receiving face of an intermediate member 200, and the top surface is in contact with the bottom surface of an intermediate member 200. Specifically, when the light-receiving faces of intermediate members 200 are directed upwards, the bottom surface of each of the concave-convex members 302 is in contact with the light-receiving face of an intermediate member 200 and the top surface is in contact with the bottom surface of an intermediate member 200. Conversely, when the light-receiving faces of intermediate members 200 are directed downwards, the top surface of each of the concave-convex members 302 is in contact with the light-receiving face of an intermediate member 200, and the bottom surface is in contact with the bottom surface of an intermediate member 200. In either case, the concave-convex members 302 have first concavities/convexities formed on the faces opposing the light-receiving faces of the intermediate members 200, and have second concavities/convexities formed on the faces in contact with the bottom surfaces of the intermediate members 200.

By means of this embodiment as well, advantageous results similar to those of the first embodiment can be obtained.

### (Fourth Embodiment)

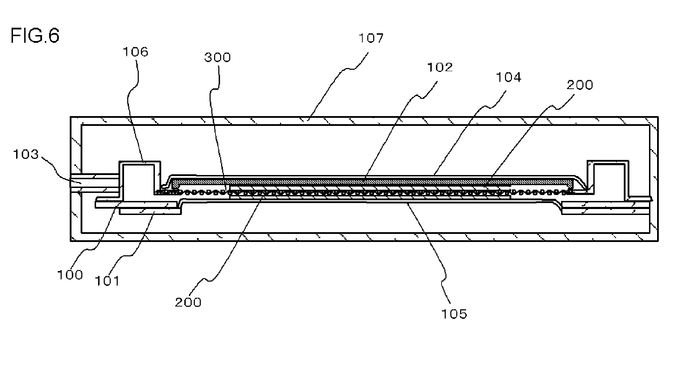

Fig. 6 is a cross-sectional view used to explain the configuration of a laminating device used in the method of manufacturing photovoltaic modules of a fourth embodiment. The laminating device of this embodiment is configured similarly to the laminating device of the first embodiment, except in the following respects.

First, a concave-convex member 300 is stretched across the entire face on the inside of the framework 106. The concave-convex member 300 has similar concavities/convexities on both faces. The lamination frame 100 also has a frame shape. Further, a second diaphragm sheet 105 is provided so as to seal the open portion of the lamination frame 100. The second diaphragm sheet 105 is mounted on the bottom surface of the lamination frame 100 using a mounting jig 101.

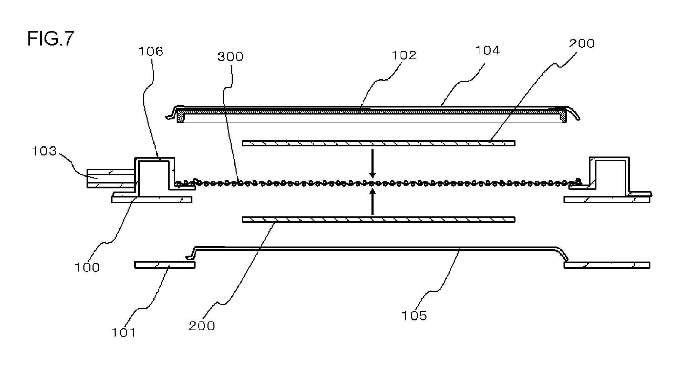

Fig. 7 is a view used to explain a method of manufacturing photovoltaic modules using the laminating device shown in Fig. 6. First the diaphragm sheet 104 and upper lid 102 are removed from the framework 106, and the second diaphragm sheet 105 is removed from the lamination frame 100. Then, an intermediate member 200 is placed on a concave-convex member 300, and an intermediate member 200 is also disposed on the rear-surface side of the concave-convex member 300. The diaphragm sheet 104 and upper lid 102 are then disposed on the framework 106, and in addition the second diaphragm sheet 105 is mounted on the lamination frame 100. Next, evacuation is performed from the evacuation port 103. By this means, the two intermediate members 200 are subjected to atmospheric pressure, which acts via the diaphragm sheet 104 and the second diaphragm sheet 105. When in this state a heating furnace 107 is used to heat the stacked member of the intermediate members 200 and the concave-convex member 300, the photovoltaic cells 202 are sealed by the protective films 204 and 206, and a photovoltaic module is formed.

By means of this embodiment as well, advantageous results similar to those of the first embodiment can be obtained.

### (Fifth Embodiment)

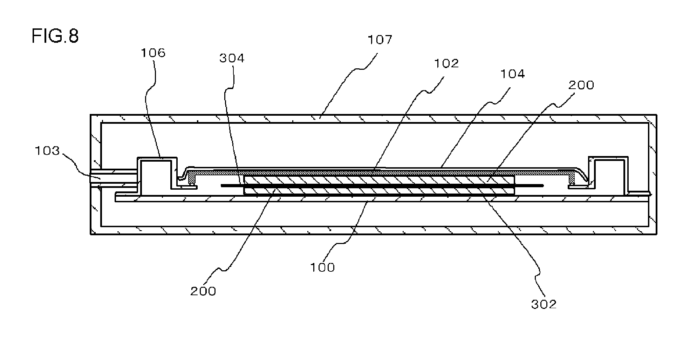

Fig. 8 is a cross-sectional view used to explain the method of manufacturing photovoltaic modules of a fifth embodiment. The method of manufacturing photovoltaic modules of this embodiment is similar to the method of manufacturing photovoltaic modules of the first embodiment, except in the following respects.

First, two intermediate members 200 are disposed with light-receiving faces in mutual opposition. Between the two intermediate members 200 is disposed a concave-convex member 304. The concave-convex member 304 has similar concavities/convexities on both faces.

By means of this embodiment as well, advantageous results similar to those of the first embodiment can be obtained.

In the above, embodiments of the invention have been explained, referring to the drawings; but these embodiments are examples of the invention, and various configurations other than the above can be adopted.

This application claims priority on the basis of Japanese Patent Application No. 2010-198095, filed on September 3, 2010, the entire contents of which are incorporated herein by reference.

## Claims

1. A method of manufacturing a photovoltaic module,
the method comprising:
a step of forming a stacked member, in which a plurality of photovoltaic cells each sandwiched between protective films for lamination sealing and at least one concave-convex member are superposed, in a state in which all the protective films positioned on a side of light-receiving faces of the photovoltaic cells oppose the concave-convex member; and
a step of simultaneously and individually sealing the plurality of photovoltaic cells by the protective film by implementing simultaneous lamination treatment on the stacked member.

2. The method of manufacturing a photovoltaic module according to Claim 1, wherein the plurality of photovoltaic cells in the stacked member have light-receiving faces oriented alternately in upward and downward directions.

3. The method of manufacturing a photovoltaic module according to Claim 2, wherein the stacked member has at least one second stacked member formed of two photovoltaic cells, the bottom surfaces of which are mutually opposed, and a separation sheet sandwiched between the two photovoltaic cells.

4. The method of manufacturing a photovoltaic module according to Claim 3, wherein
the stacked member comprises at least two second stacked members, and
the concave-convex member having same concavities and convexities formed on both faces is positioned between the second stacked members.

5. The method of manufacturing a photovoltaic module according to Claim 1, wherein
the plurality of photovoltaic cells have light-receiving faces directed in the same direction, and
in the stacked member, the concave-convex members and the photovoltaic cells are superposed in alternation.

6. The method of manufacturing a photovoltaic module according to Claim 5, wherein the concave-convex member has first concavities/convexities formed on a first surface opposing a light-receiving face, and has second concavities/convexities formed on a second face which is a face on a side opposite the first face.

7. The method of manufacturing a photovoltaic module according to Claim 1, wherein the stacked member comprises:
two photovoltaic cells the light-receiving faces of which are mutually opposed; and
the concave-convex member, positioned between the two photovoltaic cells having the same concavities/convexities formed on both faces.
